# EUROPEAN PATENT APPLICATION

(11) **EP 1 072 693 A1**
(43) Date of publication of application: **31.01.2001**
(21) Application number: 00306169.4
(22) Date of filing: 20.07.2000
(51) Int. Cl.: C23C 16/458, C23C 16/02, C23C 16/26, C01B 31/02

(54) **Chemical vapor deposition apparatus and method of synthesizing carbon nanotubes using the apparatus**

(30) Priority: 27.07.1999 KR 9930700; 29.06.2000 KR 0036509
(71) Applicant: Iljin Nanotech Co., Ltd., Seoul (KR); Lee, Cheol-jin, Gunsan-city, Jeonlabuk-do (KR)
(72) Inventor: Lee, Cheol-Jin, Gunsan-City, Jeonlabuk-Do (KR); Yoo, Jae-Eun, Seongbuk-gu, Seoul (KR)
(74) Representative: Browne, Robin Forsythe, Dr.

(57) **Abstract**

A chemical vapor deposition apparatus, and a method of synthesizing carbon nanotubes using the apparatus, are provided. The chemical vapor deposition apparatus synthesizes carbon nanotubes on one or more substrates, and includes a boat including a plurality of vertical shafts, along each of which is installed a plurality of support protrusions for supporting the substrates, the substrates mounted horizontally and in parallel on the support protrusions. Also, the chemical vapor deposition apparatus includes a reaction furnace having a passage at one end for supplying a reaction gas, and a passage at the other end for exhausting the reaction gas, the inside of the reaction furnace shaped like a rectangular solid to install the boat therein, and a heating unit installed outside the reaction furnace. A great number of carbon nanotubes can be synthesized using this chemical vapor deposition apparatus.

## Description

### BACKGROUND OF THE INVENTION

### 1. Field of the Invention

The present invention relates to synthesization of carbon nanotubes, and more particularly, to a chemical vapor deposition (CVD) apparatus for synthesizing a large number of carbon nanotubes, and a method of synthesizing carbon nanotubes using the CVD apparatus.

### 2. Description of the Related Art

It is known that a carbon nanotube is a microscopic combination of three adjacent carbon atoms with one carbon atom, a hexagonal ring is formed by combining these carbon atoms, and a plane obtained by repeating the hexagonal rings to form a honeycomb structure is rolled to form a cylinder. Also, it is known that this cylindrical structure generally has a diameter of several to several tens of nm, and a length which is several tens to several thousands of times greater than the diameter. This carbon nanotube can exhibit a wide range of properties ranging from conductivity to semiconductor-related characteristics according to its application, and is expected to be capable of being applied to various technical fields in various ways.

Recently, several methods for synthesizing carbon nanotubes have been proposed. For example, an arc discharge method has been widely known as a technique for synthesizing a great number of carbon nanotubes. The arc discharge method is a method of growing carbon nanotubes by arc discharge using carbon as an electrode. In the arc discharge method, it is difficult to control the diameter or length of a carbon nanotube and to control the structure of a produced carbonaceous material. Hence, it is difficult to obtain a material having an excellent crystalline structure during synthesization, and amorphous carbon lumps in addition to carbon nanotubes are simultaneously produced in large quantities. Accordingly, a complicated refining process must be performed after the synthesization of carbon nanotubes. Also, in the arc discharge method, a large number of carbon nanotubes cannot be grown on a large-sized substrate. Thus, the application of the arc discharge method to a variety of devices is restricted.

Instead of the arc discharge method using an electrical discharge apparatus, other methods have been proposed to synthesize carbon nanotubes. For example, a method using a laser deposition apparatus, a method using a plasma chemical vapor deposition apparatus, a thermochemical vapor deposition apparatus, and the like have been proposed. However, it is very difficult for these conventional methods or apparatuses to synthesize a great number of carbon nanotubes.

### SUMMARY OF THE INVENTION

An object of the present invention is to provide a chemical vapor deposition (CVD) apparatus for synthesizing a great number of carbon nanotubes.

Another object of the present invention is to provide a method of synthesizing a great number of carbon nanotubes using the CVD apparatus.

To achieve the first object, an aspect of the present invention provides a chemical vapor deposition apparatus for synthesizing carbon nanotubes on one or more substrates, the apparatus including a boat including a plurality of vertical shafts, along each of which is installed a plurality of support protrusions for supporting the substrates, the substrates mounted horizontally and in parallel on the support protrusions. Also, the chemical vapor deposition apparatus includes a reaction furnace having a passage at one end for supplying a reaction gas, and a passage at the other end for exhausting the reaction gas, the inside of the reaction furnace shaped like a rectangular solid to install the boat therein, and a heating unit installed outside the reaction furnace.

Here, the boat is a three-dimensional frame formed with at least four vertical shafts arranged to form a rectangle, and horizontal rods which are connected between the ends of adjacent vertical shafts.

To achieve the second object, an aspect of the present invention provides a method of synthesizing carbon nanotubes, in which, first, a catalytic metal film is formed on a substrate. Then, a plurality of substrates are horizontally mounted on support protrusions in parallel with each other in a chemical vapor deposition apparatus including a boat having the support protrusions and a plurality of vertical shafts, each of which the support protrusions are installed along, a reaction furnace having passages for supplying and exhausting a reaction gas on both ends, the inside of which is shaped of a rectangular solid to install the boat therein, and a heating unit installed outside the reaction furnace. Following this, nano-sized catalytic metal particles are formed by etching the catalytic metal film using an etch gas supplied to the reaction furnace. Thereafter, carbon nanotubes are vertically grown on the catalytic metal particles by supplying a carbon source gas to the reaction gas.

According to the present invention, a CVD apparatus for growing a great number of carbon nanotubes can be provided.

### BRIEF DESCRIPTION OF THE DRAWINGS

The above objectives and advantage of the present invention will become more apparent by describing in detail a preferred embodiment thereof with reference to the attached drawings in which:
FIGS. 1 and 2 are schematic views of a chemical vapor deposition apparatus which is used to synthesize a great number of carbon nanotubes, according to an embodiment of the present invention; and
FIGS. 3 through 6 are cross-sectional views for illustrating a method of synthesizing a great number of carbon nanotubes using a CVD apparatus according to an embodiment of the present invention.

### DESCRIPTION OF THE PREFERRED EMBODIMENT

Hereinafter, an embodiment of the present invention will be described in detail with reference to the attached drawings. However, the embodiment of the present invention can be modified into various other forms, and the scope of the present invention must not be interpreted as being restricted to this embodiment. The embodiment of the present invention is provided to more completely explain the present invention to those skilled in the art. In the drawings, the thicknesses of layers or regions are exaggerated for clarity. Like reference numerals in the drawings denote the same members. Also, when it is written that a layer is formed "on" another layer or a substrate, the layer can be formed directly on the other layer or the substrate, or other layers can intervene therebetween.

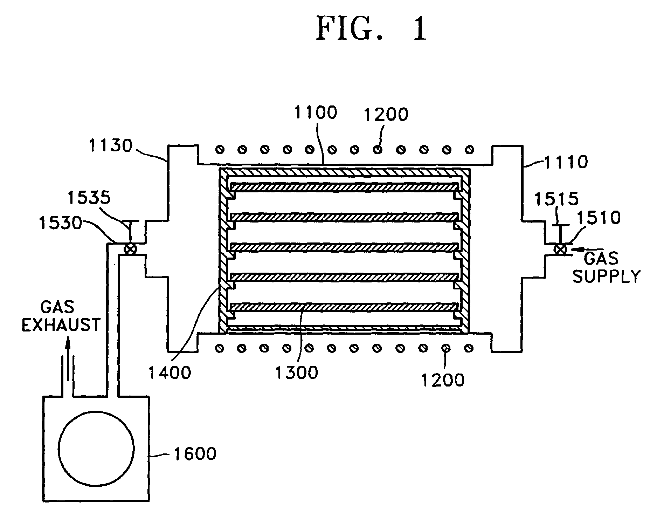

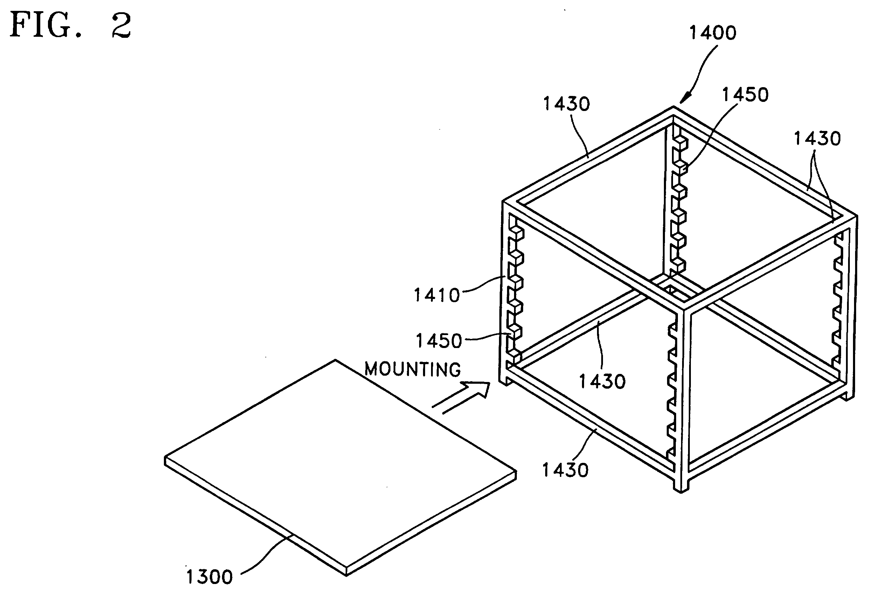

FIG. 1 is a schematic view showing the structure of a chemical vapor deposition apparatus according to a preferred embodiment of the present invention, and FIG. 2 is a schematic view of a boat according to a preferred embodiment of the present invention which is used in the chemical vapor deposition apparatus.

Referring to FIG. 1, a chemical vapor deposition apparatus for synthesizing carbon nanotubes, according to the present invention, includes a reaction furnace 1100, a heating unit 1200, and a boat 1400 on Which a substrate 1300 is mounted. The reaction furnace 1100 has a shape which allows the boat 1400 to be mounted thereon. Accordingly, the internal shape of the reaction furnace 1100 is determined by the shape of the boat 1400.

The boat 1400 is shaped so that a plurality of large substrates 1300, on which carbon nanotubes are to be synthesized, are mounted thereon. For example, the boat 1400 can be a three-dimensional frame shaped like a rectangular solid, which allows a plurality of substrates 1300 to be mounted horizontally in parallel.

That is, as shown in FIG. 2, the boat 1400 is formed with at least four vertical shafts 1410 which are arranged to form a rectangle, and horizontal rods 1430 connected between the ends of adjacent vertical shafts 1410. Here, a plurality of large substrates 1300 are installed within the internal space of a frame shaped like a rectangular solid. In order to achieve this, each of the vertical shafts 1410 has a plurality of support protrusions 1450 aligned at predetermined intervals along the length of the vertical shaft 1410. The support protrusions 1450 support the substrates 1300 so that the substrates 1300 are separated from each other at a regular interval and arranged vertically in parallel with each other.

The boat 1400 is made of a material, the shape of which is not deformed or the quality of Which is not changed at a temperature required for synthesizing carbon nanotubes, for example, quartz. Accordingly, a frame formed with the vertical shafts 1410 and the horizontal rods 1430, and the support protrusions 1450 can be made of quartz and processed to be incorporated in a body. Also, the frame formed with the vertical shafts 1410 and the horizontal rods 1430, and the support protrusions 1450, are each made of quartz and then connected to each other by various connecting methods. In this way, the boat 1400 described above can be formed.

As described above, the boat 1400 is formed as a three-dimensional frame, for example, a frame shaped of a rectangular solid which allows several large substrates 1300, for example, large rectangular substrates 1300, to be mounted thereon, so that the inside of the reaction furnace 1100 is shaped so that the boat 1400 is installed therein. For example, the reaction furnace 1100, the inside of which is a rectangular solid, is formed. Passages 1510 and 1530 for supplying and exhausting a reaction gas are formed on both ends 1110 and 1130 of the reaction furnace 1100. Valves 1515 and 1535 are installed on the passages 1510 and 1530, respectively, to control the amount of supply and exhaust of a reaction gas.

A pump 1600 is also installed at the exhaust passage 1530 to provide a driving force for exhausting a reacted gas. The pump 1600 can be a rotary pump, and can also be used to maintain the pressure of the reaction furnace 1100 to be lower than the atmospheric pressure. That is, the inside of the reaction furnace 1100 can be maintained at the atmospheric pressure according to the conditions of synthesization of carbon nanotubes, or can be required to be maintained at about 0.1 Torr to several tens of Torr as needed. Accordingly, the pump 1600 can be used to adjust the pressure of the reaction furnace 1100 to a pressure which is lower than the atmospheric pressure.

The heating unit 1200 such as a resistance heating unit shaped of a coil is disposed at the outer circumference of the reaction furnace 1100 to control the temperature-of the reaction furnace 1100. The temperature of the reaction furnace 1100 varies according to various conditions needed for synthesizing carbon nanotubes, but is controlled to remain in a temperature range between about 500°C and 1100°C. Accordingly, a thermocouple (not shown) is introduced within the reaction furnace 1100, and controls the heating degree of the heating unit 1200, thereby controlling the temperature of the reaction furnace 1100 to a certain level. Meanwhile, a heat shield material (not shown) is introduced around the reaction furnace 1100, and maintains the temperature of the reaction furnace 1100 to be uniform.

In a case where carbon nanotubes are synthesized or grown using a chemical vapor deposition apparatus according to an embodiment of the present invention as described above, a great number of carbon nanotubes can be produced. To be more specific, large substrates 1300 can be mounted in parallel in the boat 1400 of a reaction chamber 1100. Thus, carbon nanotubes can be synthesized and grown simultaneously on several large substrates 1300 by a one-time carbon nanotube synthesizing process.

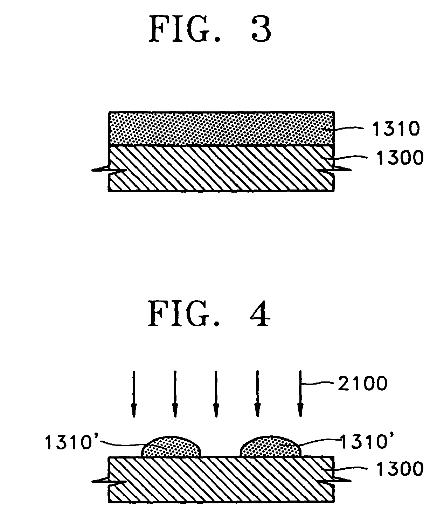

FIGS. 3 through 6 are cross-sectional views schematically illustrating a method of synthesizing a great number of carbon nanotubes, according to an embodiment of the present invention. This method uses a CVD apparatus according to an embodiment of the present invention as shown in FIGS. 1 and 2.

FIG. 3 schematically illustrates the step of forming a catalytic metal film 1310 on a large substrate 1300.

To be more specific, the large substrate 1300 is prepared, and the catalytic metal film 1310 is formed on the large substrate 1300 to have a thickness of about several to several hundreds of nm, preferably, about 20 nm to 100nm. The large substrate 1300 can be formed of various materials in various shapes depending on the purpose of its use. However, it is preferable that the substrate 1300 is formed of glass, quartz, silicon, alumina (Al₂O₃), or silicon oxide in a rectangular shape.

The catalytic metal film 1310 is used as a catalyst when carbon nanotubes are synthesized thereon in vertical alignment. Accordingly, the catalytic metal film 1310 can be formed of a transition metal material capable of acting as a catalyst during synthesization of carbon nanotubes, for example, cobalt (Co), nickel (Ni), iron (Fe), yttrium (Y), or an alloy of two or more of the above materials (for example, cobalt-nickel, cobalt-iron, cobalt-yttrium, nickel-iron, cobalt-iron or cobalt-nickel-yttrium).

The catalytic metal film 1310 can be formed by various methods of forming a thin metal film, for example, a thermal evaporation method, a sputtering method or the like.

The substrates 1300, on which the catalytic metal film 1310 has been formed as described above, are mounted in the boat 1400 according to an embodiment of the present invention shown in FIG. 2. That is, the substrates 1300 are mounted on the support protrusions 1450 of the boat 1400 horizontally and in parallel. The support protrusions 1450 are formed on each of the vertical shafts 1410 and are spaced from each other at regular intervals along the vertical shaft 1410, so that the mounted substrates 1300 are spaced from each other at regular intervals.

The boat 1400, into which several large substrates 1300 have been introduced as described above, is installed within the reaction furnace 1100 of FIG. 1. At this time, the substrates 1300 can be mounted on the support protrusions 1450 after the boat 1400 is installed within the reaction furnace 1100. As described above, several large substrates 1300 are introduced into the reaction furnace 1100, the inside of the reaction furnace 1100 is purged using a nitrogen gas or an inert gas, and the pressure of the reaction furnace 1100 is adjusted to a pressure which is required for a subsequent process.

FIG. 4 schematically illustrates the step of forming catalytic metal particles 1310' by etching the catalytic metal film 1310. To be more specific, a plurality of substrates 1300 are introduced into the reaction furnace 1100 as described above, and then the pressure of the reaction furnace 1100 is kept at an atmospheric pressure or about 0.1 Torr to several tens of Torr. The temperature of the reaction furnace 1100 is increased by the heating unit 1200, and then an etch gas capable of grain boundary etching the catalytic metal film 1310, such as, an ammonia (NH₃) gas, is supplied to the reaction furnace 1100. The etch gas is supplied via the supply passage 1510 installed at the entrance end 1110 of the reaction furnace 1100, and the flow rate of the etch gas can be controlled by the valve 1515.

The etch gas is used to form the catalytic metal particles 1310' by etching the catalytic metal film 1310. Here, it is preferable that the etch gas etches the catalytic metal film 1310 while flowing along the grain boundary of the catalytic metal film. In order to achieve this grain boundary etching, activating the etch gas is indispensable. That is, preferably, the ammonia gas is dissociated before it reaches the location of the substrates 1300 introduced within the boat 1400 of the reaction furnace 1100, and then the ammonia gas is activated.

When an ammonia gas is used as the etch gas, pyrolysis can be used to activate the ammonia gas. Hence, it is preferable that the temperature of the reaction furnace 1100 is kept at at least a temperature where an ammonia gas can be dissociated by pyrolysis, for example, at 700° C or greater. More preferably, the temperature of the reaction furnace 1100 is kept at about 700 to 1100 °C.

An ammonia gas supplied to the reaction furnace 1100, which is kept at the above-described temperature, is dissociated by pyrolysis, and the dissociated ammonia gas 2100 etches the grain boundaries on the catalytic metal film 1310. Here, the flow rate of the ammonia gas supplied to the reaction furnace 1100 can be about 80 to 1000 sccm (standard cubic centimeter per minute), and the etching process using an ammonia gas can be performed for about 10 to 30 minutes.

Meanwhile, it is preferable that an ammonia gas is used as an etch gas as described above, but a hydrogen gas, a hydride gas, or a mixed gas of the above-described gases can be used instead of an ammonia gas as needed.

Preferably, grain boundary etching of the catalytic metal film 1310 using the activated ammonia gas 2100, is performed until the substrate 1300 below the catalytic metal film 1310 is exposed. Thus, isolated catalytic metal particles 1310' of nano sizes (the nano size in this specification denotes several to several hundreds of nm) are formed. Practically, the catalytic metal particles 1310' act as a catalyst during a subsequent carbon nanotube synthesizing process.

The size of the catalytic metal particles 1310' can be controlled by adjusting the initial thickness of the catalytic metal film 1310, the amount of supply of ammonia gas during the above-described grain boundary etching, the temperature during an etching process, or the time for which the etching process is performed. The nano-sized catalytic metal particles 1310', which are separated from each other independently, are formed by grain boundary etching, so that they can be finely distributed on the substrate 1300 with a uniform density. The size and shape of the separated nano-sized catalytic metal particles 1310' vary according to the etching conditions, but it is preferable that the catalytic metal particles 1310' in an embodiment of the present invention are formed to be about 10 nm to 60 nm.

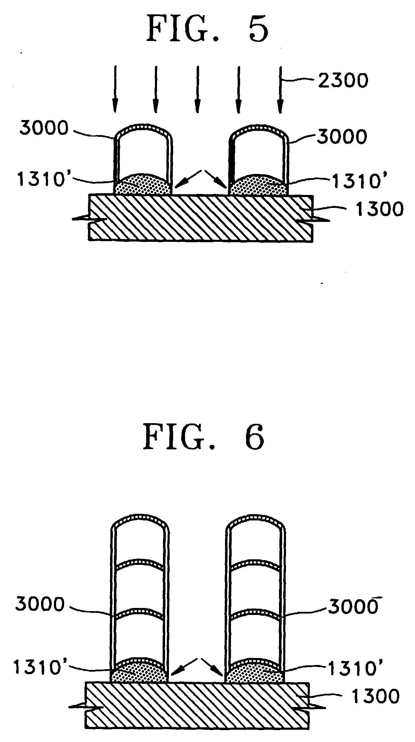

FIG. 5 schematically illustrates the step of forming carbon nanotubes 3000 on the catalytic metal particles 1310'. To be more specific, after the catalytic metal particles 1310' are formed as described above, supply of the analyzed ammonia gas 2100 is stopped, and a carbon source gas 2300 is introduced into the reaction furnace 1100 via the supply passage 1510 to be supplied over the catalytic metal particles 1310' on each of the substrates 1300. The carbon source gas 2300 can be a hydrocarbon gas capable of supplying a carbon dimer. The hydrocarbon gas can be a hydrocarbon gas containing at most about 20 carbon atoms, for example, an acetylene gas, an ethylene gas, a propylene gas, a propane gas or a methane gas. Preferably, an acetylene gas is used as the hydrocarbon gas 2300.

Also, it is preferable that the temperature of the reaction furnace 1100 is kept at a temperature where a carbon source gas can be transformed into a carbon dimer, for example, at about 500 to 1100 °C. Here, an acetylene gas used as the carbon source gas 2300 can be supplied for about 10 to 60 minutes at a flow rate of about 20 to 500 sccm. At this time, preferably, the pressure of the reaction furnace 1100 is kept at a low pressure of about 0.1 Torr to several tens of Torr.

The carbon source gas 200 supplied to the reaction furnace 1100 is dissociated by pyrolysis, and forms carbon units. The carbon units formed by pyrolysis are adsorbed on the surface of the separated nano-sized catalytic metal particles 1310' and diffused thereinto. At this time, the carbon units are transformed into carbon dimers (C=C) on the surface of the catalytic metal particles 1310' or within the catalytic metal particles 1310'.

Meanwhile, when the catalytic metal particles 1310' are super-saturated by the carbon dimers, the carbon dimers react to each other and thus form a two-dimensional honeycomb structure in which a plurality of hexagonal rings are connected. Thereafter, when carbon dimers are continuously supplied to the catalytic metal particles 1310', carbon nanotubes 3000 each having the honeycomb structure are synthesized on the catalytic metal particles 1310'.

FIG. 6 schematically shows the step of synthesizing the carbon nanotubes 3000 so that they are vertically oriented. To be more specific, formed nanotubes 3000 can be synthesized by continuously supplying carbon dimers. Practically, when carbon dimers are continuously supplied to the edges of the catalytic metal particles 1310', the carbon nanotubes 3000 are continuously synthesized. At this time, when the density of the catalytic metal particles 1310' is sufficiently high, the carbon nanotubes 3000 are synthesized on a plurality of distributed catalytic metal particles 1310' so that they are vertically oriented by pushing each other. Meanwhile, when this synthesization of carbon nanotubes 3000 is continued, the carbon nanotubes 3000 can have a bamboo structure.

The catalytic metal particles 1310', which are suitable for synthesizing the carbon nanotubes 3000, are independently formed without being agglomerated with other neighboring catalytic metal particles 1310', so that the carbon nanotubes 3000 are also formed independently without being agglomerated with each other. That is, amorphous carbon agglomerates are prevented from being formed while the carbon nanotubes 300 are formed. Thus, highly-pure carbon nanotubes 3000 can be formed and oriented vertically on the substrate 1300.

In order for the carbon nanotubes 3000 to be produced having a higher purity, the step of synthesizing and then refining the carbon nanotubes 3000 as described above can be further performed. For example, transition metal agglomerates or carbon particles that can exist in the carbon nanotubes 3000 are eliminated by stopping the supply of the carbon source gas 2300 as described above and supplying an ammonia gas or a hydrogen gas to the reaction furnace 1100. Transition metal agglomerates can exist outside the catalytic metal particles 1310', and can generally exist at the ends of a carbon nanotube 3000. Also, carbon particles can exist on the surface of a carbon nanotube 3000.

An ammonia gas or hydrogen gas for refining as described above, preferably, an ammonia gas, can be supplied to the reaction furnace 1100 for about 10 to 30 minutes at a flow rate of about 80 to 1000 sccm. Here, it is preferable that the temperature of the reaction furnace 1100 is kept at about 500 to 1000 °C. Carbon particles or transition metal agglomerates, that can exist on the surface or edges of each carbon nanotube 3000, can be eliminated by a refining step as described above, so that highly-pure carbon nanotubes 3000 can be formed and synthesized.

According to the present invention described above, a chemical vapor deposition apparatus, by which several large substrates can be introduced into a reaction furnace simultaneously, can be provided, so that carbon nanotubes can be synthesized on each of the several large substrates. Therefore, a great number of carbon nanotubes can be synthesized.

Although the invention has been described with reference to a particular embodiment, it will be apparent to one of ordinary skill in the art that modifications of the described embodiment may be made without departing from the spirit and scope of the invention.

## Claims

1. A chemical vapor deposition apparatus for synthesizing carbon nanotubes on one or more substrates, the apparatus comprising:
a boat including a plurality of vertical shafts, along each of which is installed a plurality of support protrusions for supporting the substrates, the substrates mounted horizontally and in parallel on the support protrusions;
a reaction furnace having a passage at one end for supplying a reaction gas, and a passage at the other end for exhausting the reaction gas, the inside of the reaction furnace shaped like a rectangular solid to install the boat therein; and
a heating unit installed outside the reaction furnace.

2. The chemical vapor deposition apparatus of claim 1, wherein the substrates are rectangular.

3. The chemical vapor deposition apparatus of claim 1, wherein the boat is a three-dimensional frame formed with at least four vertical shafts arranged to form a rectangle, and horizontal rods which are connected between the ends of adjacent vertical shafts.

4. The chemical vapor deposition apparatus of claim 1, wherein the frame forms an internal space shaped like a rectangular solid with the vertical shafts and the vertical rods so that the substrates are introduced thereinto.

5. The chemical vapor deposition apparatus of claim 1, wherein the boat is made of quartz.

6. A method of synthesizing carbon nanotubes, the method comprising:
forming a catalytic metal film on a substrate;
horizontally mounting a plurality of substrates on support protrusions in parallel with each other in a chemical vapor deposition apparatus including a boat having the support protrusions and a plurality of vertical shafts, each of which the support protrusions are installed along, a reaction furnace having passages for supplying and exhausting a reaction gas on both ends, the inside of which is shaped of a rectangular solid to install the boat therein, and a heating unit installed outside the reaction furnace;
forming nano-sized catalytic metal particles by etching the catalytic metal film using an etch gas supplied to the reaction furnace; and
vertically growing carbon nanotubes on the catalytic metal particles by supplying a carbon source gas to the reaction gas.

7. The method of claim 6, wherein the substrate is made of a material selected from the group consisting of glass, quartz, silicon, alumina and silicon oxide.

8. The method of claim 6, wherein the catalytic metal film is made of a material selected from the group consisting of cobalt, nickel, iron, yttrium and an alloy of two or more of the materials.

9. The method of claim 6, wherein the catalytic metal film is formed to a thickness of about 20 to 100 nm.

10. The method of claim 6, wherein the etch gas is an ammonia gas, a hydrogen gas or a hydride gas.

11. The method of claim 10, wherein the etch gas is an ammonia gas.

12. The method of claim 11, wherein in the step of forming catalytic metal particles, the temperature of the reaction furnace is maintained at or over a temperature where the ammonia gas is dissociated by pyrolysis.

13. The method of claim 12, wherein the temperature of the reaction furnace is kept at about 700 to 1100 °C.

14. The method of claim 6, wherein the carbon source gas is a hydrocarbon gas containing 1 to 20 carbon atoms.

15. The method of claim 14, wherein the carbon source gas is selected from the group consisting of an acetylene gas, an ethylene gas, a propylene gas, a propane gas and a methane gas.

16. The method of claim 6, wherein the carbon source gas is supplied while the temperature of the reaction furnace is kept at about 500 to 1100 °C.

17. The method of claim 6, after the step of growing carbon nanotubes, further comprising refining the grown carbon nanotubes with an ammonia gas or hydrogen gas further supplied to the reaction furnace.

18. The method of claim 17, wherein in the carbon nanotube refining step, the temperature of the reaction furnace is kept at about 500 to 1000 °C.

19. The method of claim 6, wherein the pressure of the reaction gas is kept at an atmospheric pressure or at about 0.1 to several tens of Torr.
